Europäisches Patentamt

(19) European Patent Office

Office européen des brevets

(11) **EP 0 840 462 B1**

(12) **EUROPEAN PATENT SPECIFICATION**

(45) Date of publication and mention
of the grant of the patent:
**15.12.2004 Bulletin 2004/51**

(51) Int Cl.7: **H03M 13/00**, H03M 13/09,
H04L 1/00

(21) Application number: **97480052.6**

(22) Date of filing: **19.08.1997**

(54) **A method and apparatus for a two-step calculation of CRC-32**

Verfahren und Vorrichtung für zweistufige CRC-32-Berechnung

Méthode et appareil pour le calcul en 2 étapes d'un CRC-32

(84) Designated Contracting States:
**DE FR GB**

(30) Priority: **29.10.1996 EP 96480104**

(43) Date of publication of application:
**06.05.1998 Bulletin 1998/19**

(73) Proprietor: **International Business Machines
Corporation
Armonk, N.Y. 10504 (US)**

(72) Inventor: **Glaise, René
06000 Nice (FR)**

(74) Representative: **Therias, Philippe
Compagnie IBM FRANCE,
Département de Propriété Intellectuelle
06610 La Gaude (FR)**

(56) References cited:
EP-A- 0 614 294          EP-A- 0 735 711
US-A- 4 720 830          US-A- 5 062 111

• "METHOD TO PROVIDE SOFTWARE
CALCULATION OF A 32-BIT FRAME CHECK
SEQUENCE, A BYTE AT A TIME" IBM
TECHNICAL DISCLOSURE BULLETIN,US,IBM
CORP. NEW YORK, vol. 30, no. 12, 1 May 1988
(1988-05-01), pages 458-464, XP000022463 ISSN:
0018-8689

## Description

Field of the invention

This invention relates to error code calculation for data integrity checking in high speed telecommunications networks. The invention can be applied to Asynchronous Transfer Mode (ATM) network in which high speeds require a fast process for data integrity checking.

Background of the invention

When digital messages are transmitted over telecommunication networks some errors can be expected and to insure data integrity, the serialized data is protected with Error Detection Codes. In high speed networks the lines have a low error rate and the security of data only requires a end to end process. The data integrity process is carried out at both the sending and the receiving station; the sending station calculates a code corresponding to the data and the transmitting station checks the integrity of the data and code. ATM uses a Frame Check Sequence (FCS) field derived from Cyclic Redundancy Check (CRC) Error Detection codes for error checking. The CRC codes are often used for checking integrity of data because they are easy to implement and they detect a large class of errors. The access nodes of an ATM network having the responsibility of data integrity, the originating node calculates the redundancy bits constituting the Frame Check Sequence, (FCS) which is appended by the originating system to the bit stream to be checked before sending it over the network. At the end node, the bit stream plus its initial FCS are checked using similar CRC computation. There is no error in transmission if the computed FCS at the end node yields a constant value depending on the type of CRC used. It is noted that in an ATM network the FCS calculation and checking are performed in the ATM adapter cards of ATM access nodes (et the entry of the network), in ATM connected user ends stations, and also in ATM nodes providing internetworking functions such as ATM-Frame Relay.

CRC codes are generated by a generator polynomial characterizing the type of CRC; the CRC code corresponding to the polynomial representation of a bit stream to be encoded is the remainder of the polynomial division of the polynomial representation of the bit stream by the polynomial generator. CRC calculations are described, for instance, in 'TUIUinformatique I' of Henri Nussbaumer, 1987, Presses informatiques romandes CH-1015 Lausanne. The FCS code has been standardized for data integrity checking as described in the ANSI X3.139-1987 document pages 28 and 29 and in the Appendix B. All the CRC codes constitute a finite Galois Field. If the polynomial generator is of degree d, the Galois Field of the CRC codes has $2^d$ -1 elements. The simple implementation of codes based on CRC is due to the simple characteristics of calculations in the finite Galois Fields.

In ATM networks different types of connections may be established depending on the quality of service required. Some ATM standards organizations (ITU-T The International Telecommunication Union - Telecommunication and ETSI The European Telecommunication Standardization Institute ) have standardized different ATM Adaptation Layers (AALs) to provide generalized interworking across the ATM network. In the case of data, this AAL function takes frames (blocks) of data delivered to the ATM network, breaks them up into cells and adds necessary header information to allow rebuilding of the original block at the receiver. The AAL function includes checking for errors. The AAL function is implemented in the ATM end point which connects to the ATM network over the User Network Interface (UNI). As ATM switches usually contain endpoint functions as well as switch functions, AAL function is also implemented in ATM switches. Different AALs correspond to different traffic types. For instance, if AAL1 is used for the service class A, circuit emulation, AAL3/4 provides an end-to-end transport for both connection oriented (class C) and connectionless data (class D). AAL5 is designed to operate significantly more efficiently than AAL3/4. It has become the I.364 ITU-T standard. The implementation of the AAL5 function is characterized by its low cost, compared to the other AAL implementations, in terms of overhead in the network nodes.

The ATM cell headers have their own error checking based on FCS calculation. The payload of 384 bits (48 bytes) of some ATM cells also uses FCS redundancy bits for error checking. The last 32 bits of cell payload of the last cell of a message conveyed through an AAL5 type connection represents the FCS code calculated on the message. The FCS code used for AAL5 cells is based on the CRC-32 codes calculations. We can represent bit streams as polynomials having coefficients values of 0 or 1, each power of X representing the weight of the bit in the stream. The addition of such polynomials correspond to logical addition (XORs) on their coefficients. The CRC-32 codes belong to the Galois Field generated by the following generator polynomial of degree 32 :

$$G(X) = X^{32}+X^{26}+X^{23}+X^{22}+X^{16}+X^{12}+X^{11}+X^{10}+X^8+X^7+X^5+X^4+X^2+X+1$$

This generator polynomial of degree 32 has been standardized for error checking in Ethernet and then chosen by the ATM standard for AAL5 error checking. The standard used for FCS calculation based on the polynomial generator of degree 32 is described in the publication 'American National Standard for information systems, fiber distributed data interface (FDDI) - token ring media access control (MAC)' ANSI X3.139-1987 of American National Standards Institute, inc..

If P(X) is the polynomial representation of a bit stream for which the 32 bit stream FCS is to be calculated we have:

$$FCS(P(X)) = L(X) + Rem_G (X^{32} P(X) + X^k L(X)) \qquad \text{(Expression 1)}$$

$$k-1 = \text{degree of } P(X)$$

$$L(X) = X^{31}+X^{30} +...+X^2+X+1$$

similarly, for FCS checking at the other side of a network when receiving a bit stream F'(X) including the appended FCS which has been calculated before sending, the checking is positive only if:

$$Rem_G (X^{32}(F'(X)+X^{k'}L(X))) = C(X) \qquad \text{(Expression 2)}$$

C(X) being the polynomial:

$$C(X) = X^{31}+X^{30}+X^{26}+X^{25}+X^{24}+X^{18}+X^{15}+X^{14}+X^{12}+X^{11}+X^{10}+X^8+X^6+X^5+X^4+X^3+X+1$$

$$k'-1 = \text{degree of } F(X)$$

$$L(X) = X^{31}+X^{30}+...+X^2+X+1$$

The FCS bottleneck in FCS computation and checking is the $Rem_G$ operation. The result is a CRC code belonging to the set of residue classes modulo G(X) of the polynomials of coefficients equal to 1 or 0 which is a ring, a linear algebra and which is a Galois Field having a multiplicative cyclic group because G(X), the generator polynomial of degree 32, is an irreducible polynomial.

The standard circuitry for computing the FCS of a bit stream message is a Linear Feedback Shift Register (LFSR) which carries out a bit by bit multiplication in the corresponding Galois Field. Each bit of the message is pushed in the LFSR, Most Significant Bit (MSB) first. The division is performed by the feedbacks. At the end of the process, the FCS (remainder of the division) is within the shift register. This method and type of circuitry is described , for instance in 'Error Checking Codes' by Peterson and Weldon, the MIT Press, 2nd edition, 1972. Although simple the method has obvious drawbacks. For example, since only one bit is processed at each shift as many shifts as the number of bits is the message are needed in the LFSR. As the 32 bit CRC is used, a 32 bit register is needed. In this LFSR the remainder is calculated on a message shifted left by 32 bit places according to Expression 1 and Expression 2 for FCS calculation and checking. Still in order to be in accordance with Expression 1 and Expression 2, the polynomial addition of $X^k L(X)$ is realized by presetting the Shift register to all ones. Computing the CRC takes as many clock pulses as there are bits in the message.

A faster FCS calculation is provided in the patent application published under the reference EP 0614 294 entitled 'Method for generating a frame check sequence' disclosing a one (or more) byte (s) based FCS calculation, this method being more efficient than a bit based FCS calculation as with the LFSRs. This technique takes advantage of the properties of the operations in the Galois Fields. One property of the Galois Field is to have a root $\alpha$, an irreducible polynomial element of the Galois Field, characterized in that each element of the Galois Field is represented by $\alpha^d$, d being one integer greater or equal to zero and smaller than the number of elements of the Galois Field. According to a preferred embodiment described in the patent application, the calculation of FCS of a byte stream can be performed byte by byte, each new byte read being XORed with the result of the multiplication of the previous FCS value by the $\alpha^8$ element of the Galois Field. The multiplier is the implementation of the $\alpha^8$ multiplication in the Galois Field, this means modulo the polynomial generator G(X). The mathematical formula illustrating the method is expressed in the Galois Field as follows:

$$FCS(N+1) = FCS(N) \otimes \alpha^8 + B(N+1) \qquad \text{(Expression 3)}$$

Where FCS(N) is the FCS of the message consisting of the N previous bytes, B(N+1) the polynomial representation of the next byte (new byte) of the message.

$\otimes$     is the sign of the polynomial multiplication in the Galois Field. It is a two step operation comprising a first step to multiply the two polynomials and a second step to take the remainder of the result in the division by G.

$\alpha$     is an irreducible polynomial, root of the Galois Field generated by G.

$\alpha^8$     is the 9th element of the Galois Field (simple element having only one coefficient equal to 1 in its polynomial representation).

This per byte calculation of the FCS according to Expression 3 is implemented using a Multiplier adder. The ATM access nodes have this Multiplier adder implemented in their adapter cards. The Multiplier adder of the prior art when applied to the computation of CRC-32 based FCS requires the combinational operations described in the following table 1 to be implemented. The 32 bits of the FCS, as shown in the first column, calculated at the reception of a new byte N, result in the combination of the bits of the FCS calculated on the preceeding bytes (up to N-1), as shown in the second column, with the bits of the incoming new byte (B(i)). In the third column is indicated the number of XOR entries necessary to the combination of the corresponding bit. It varies from 2-way to 8-way XORs. As with the LSFR solution the register receiving the 32 bit stream CRC is preset to all ones.

Table 1.

| | | |
|---|---|---|
| FCS(0) | B(0),FCS(24,30) | 3 |
| | | |
| FCS(2) | B(2),FCS(24,25,26,30,31) | 6 |
| FCS(3) | B(3),FCS(25,26,27,31) | 5 |
| FCS(4) | B(4),FCS(24,26,27,28,30) | 6 |
| FCS(5) | B(5),FCS(24,25,27,28,29,30,31) | 8 |
| FCS(6) | B(6),FCS(25,26,28,29,30,31) | 7 |
| FCS(7) | B(7),FCS(24,26,27,29,31) | 6 |
| FCS(8) | FCS(0,24,25,27,28) | 5 |
| FCS(9) | FCS(1,25,26,28,29) | 5 |
| FCS(10) | FCS(2,24,26,27,29) | 5 |
| FCS(11) | FCS(3,24,25,27,28) | 5 |
| FCS(12) | FCS(4,24,25,26,28,29,30) | 7 |
| FCS(13) | FCS(5,25,26,27,29,30,31) | 7 |
| FCS(14) | FCS(6,26,27,28,30,31) | 6 |
| FCS(15) | FCS(7,27,28,29,31) | 5 |
| FCS(16) | FCS(8,24,28,29) | 4 |
| FCS(17) | FCS(9,25,29,30) | 4 |
| FCS(18) | FCS(10,26,30,31) | 4 |
| FCS(19) | FCS(11,27,31) | 3 |
| FCS(20) | FCS(12,28) | 2 |
| FCS(21) | FCS(13,29) | 2 |
| FCS(22) | FCS(14,24) | 2 |

Table 1. (continued)

| FCS(23) | FCS(15,24,25,30) | 4 |
|---------|------------------|---|
| FCS(24) | FCS(16,25,26,31) | 4 |
| FCS(25) | FCS(17,26,27) | 3 |
| FCS(26) | FCS(18,24,27,28,30) | 5 |
| FCS(27) | FCS(19,25,28,29,31) | 5 |
| FCS(28) | FCS(20,26,29,30) | 4 |
| FCS(29) | FCS(21,27,30,31) | 4 |
| FCS(30) | FCS(22,28,31) | 3 |
| FCS(31) | FCS(23,29) | 2 |

The CRC-32 calculation is based on a polynomial of degree 32 which has many more terms (15) than any other CRC polynomial defined by the standard organizations of the Telecommunications industry. The amount of calculations needed to handle a new incoming byte of data in a per byte computation is large if the number of terms of the polynomial is large, because a large number of bits of the current intermediate result must be combined to get each bit of the next byte. As shown on the table above, a 8-way XOR will be used for CRC-32 which is quite a complex operation. As a matter of fact, the processing complexity of the N-way increases with N. This complexity tends to go against the intrinsic speed advantage of the per byte computation by requiring that more processing be done at each cycle. That is why with current technologies (for instance standard submicron CMOS technology), it is very difficult to perform the FCS calculations for data integrity checking of payload while sustaining media speed. Particularly over OC12 (622Mbps) optical links a cell (48 bytes) should be processed in 700 ns. In the ATM adaptation layer, the FCS calculation/checking of AAL5 cells FCS should not be delayed: particularly AAL5 cells are used for network management messages which must be recognized immediately in order to enable corrective actions. If not, a significant amount of data could be mishandled, generally discarded, because some resources (buffers, bandwidth) were not allocated on time.

It is the object of the invention to reduce process time of the payload FCS calculation based on CRC-32 codes of packets sent over the network and the process of checking the cell payload FCS in of the packets received on the other side of the network.

SUMMARY OF THE INVENTION

The invention provides a method to calculate the 32-bit stream of the CRC-32 (Cyclic Redundancy Check) code generated by the polynomial generator of degree 32,

$$G(X) = X^{32}+X^{26}+X^{23}+X^{22}+X^{16}+X^{12}+X^{11}+X^{10}+X^8+X^7+X^5+X^4+X^2+X+1,$$

of an input
bit stream, said method comprising the steps of :

calculating (12) the R-bit stream of a CRC-R code generated by M(X), which is a multiple of G(X) of degree R, of the input bit stream and storing the R-bit stream of the CRC-R code (14);
performing a polynomial division of stored R-bit stream by G(X), the 32-bit stream remainder of the polynomial division being stored in a 32-bit register (18) and being the 32-bit stream of the CRC-32 code of said input bit stream.

The invention further provides the apparatus implementing the steps of the method. The method and the apparatus are used particularly for the FCS computation and checking of the AAL5 cells in ATM network nodes.

With the solution of the invention the process time is reduced compared to the solutions of the prior art and the implementation is simple; particularly the first CRC computation is implemented with 2-way XORs only and the second CRC computation is a one pass combination applied to a fixed sized bit stream, result of the first CRC computation.

BRIEF DESCRIPTION OF THE DRAWINGS

Figure 1 depicts the general process for CRC-32 computation.

Figure 2 shows the first division flow chart.

Figure 3 illustrates the bit combination according to the Multiplier/adder of the M123 first division.

Figure 4 (4A and 4B) illustrate the hardware implementation of the Multiplier/adder of the M123 first division.

Figure 5 (5A and 5B) show the matrix representation of the combinational array corresponding to the final division after a first division by M53.

Figure 6 illustrates the bit combination corresponding to the final division after a first division by M53.

Figure 7 lists some possible multipliers of the polynomial generator of degree 32 and the corresponding N-way XOR necessary to the corresponding implementation of the corresponding Multiplier/adder.

DETAILED DESCRIPTION OF THE PREFERRED EMBODIMENT

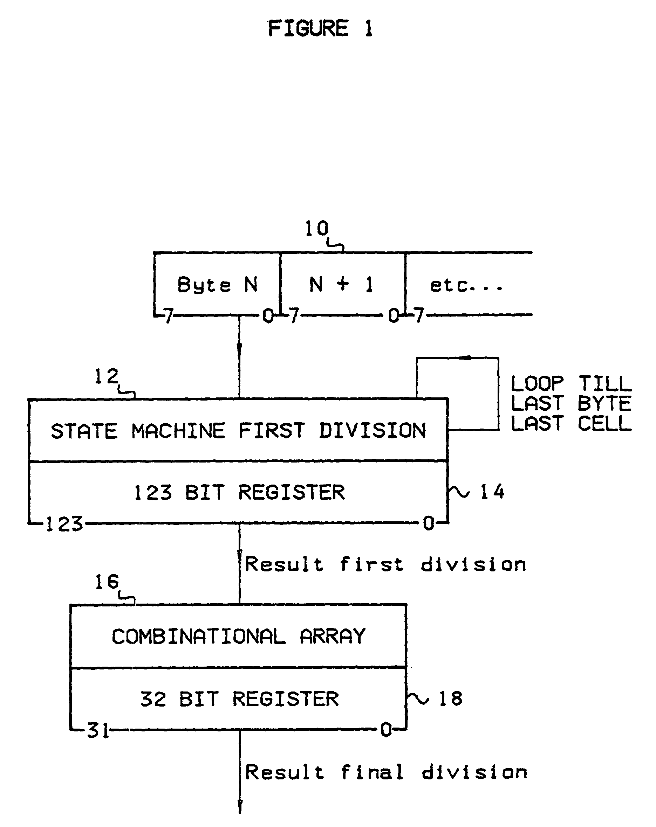

Figure 1 shows the logical blocks of the CRC-32 calculation used for the computation of the FCS of a message segmented into ATM AAL5 cells in an ATM network. According to Expression 1, the CRC-32 calculated on an input bit stream is the remainder of the polynomial division of the polynomial representation of the input bit stream by the generator polynomial of degree 32 defined at the ATM forum:

$$G(X) = X^{32}+X^{26}+X^{23}+X^{22}+X^{16}+X^{12}+X^{11}+X^{10}+X^8+X^7+X^5+X^4+X^2+X+1$$

The remainder is a polynomial of a degree smaller than 32 representing a 32 bit stream. The input bit stream, according to Expression 1, is based on the initial bit stream message. The remainder fills the 32 bit FCS field appended to the payload of the last ATM AAL5 cell of the segmented message. The same CRC-32 calculation is used for checking the integrity of a message arriving at a destination point of an ATM network according to Expression 2. For checking, the CRC-32 is calculated on the bit stream constituting the payload of all the AAL5 cells of a message, the last payload including the appended FCS according to Expression 2.

In the preferred embodiment of the CRC-32 calculation illustrated in Figure 1, the logical block (12) represents the state machine for the per byte recurrent division known from the prior art applied to the input bit stream read per byte 0, 1, ... N, N+1 etc...(10) and the polynomial divider of degree 123:

$$M123(X) = X^{123}+X^{111}+X^{92}+X^{84}+X^{64}+X^{46}+X^{23}+1$$

which is a multiplier of the polynomial generator G of degree 32:

$$G(X) = X^{32}+X^{26}+X^{23}+X^{22}+X^{16}+X^{12}+X^{11}+X^{10}+X^8+X^7+X^5+X^4+X^2+X+1$$

The remainder of the division by M123, the first division of the FCS computation, is a polynomial of degree 122 or less which is written in a 123 bit register (14). The 123 bit stream is then entered, for the preferred embodiment, in a combinational array implementing the polynomial division of the 123 bit stream by the generator polynomial of degree 32 (16); the result of this second division (the final division) is a polynomial of degree 31 or less representing a 32 bit stream written in a 32 bit register (18).

Thus, the principle used in this preferred embodiment consists in replacing the polynomial division by G by two successive polynomial divisions: one by the polynomial M123 which is a multiplier of G, the second, applied to the remainder of the first division, by the generator polynomial G of degree 32. We have the same result by analogy with ordinary numbers: the remainder of the division by a multiplier of a number g, itself divided by g is equal to the remainder of the unique division by g. It is noted that any polynomial multiplier of G(X) could be used in this calculation. For reason of simplification in the hardware implementation of the CRC-32 calculation, M123 is preferably used; in other embodiments one of the following two polynomials can be also conveniently chosen:

$$M71(X) = X^{71}+X^{57}+X^{55}+X^{48}+X^{44}+X^{36}+X^{22}+X^{15}+X^{8}+1$$

$$M53(X) = X^{53}+X^{38}+X^{36}+X^{33}+X^{30}+X^{27}+X^{25}+X^{7}+X^{3}+1$$

The best result (minimum processing cycles) is obtained when the powers of the terms are all at least 8 bits apart.

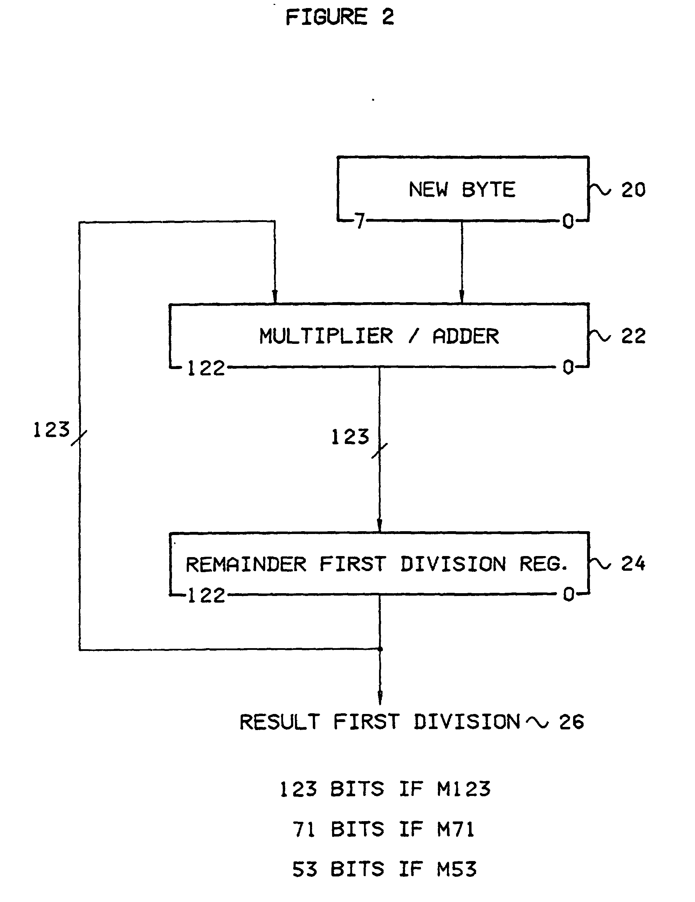

The following figures illustrate the two divisions of the logical blocks of the general process illustrated in Figure 1. Figure 2 is a flow-chart corresponding to the first division. The per byte computation of the prior art applied to an irreducible generator polynomial is applied to the non-irreducible polynomial, here M123, which is a multiplier of G(X). Each new input byte of the input bit stream is entered in the multiplier/adder of the prior art performing the CRC computation based on polynomial M123. As a matter of fact, the CRC computation is reduced to a combination of the current byte N+1 bit stream with the result of the same combination performed at the byte N. The result of the division is a 123 bit stream. The result of the division is one member of the multiplicative group generated by the polynomial M123. A primitive element α generates the multiplicative group generated by M123. The 123 bit stream representing the remainder of the division is stored in a 123 bit register (24). This result is then re-entered in the Multiplier/Adder (22) in combination with the entering new byte. When the last byte corresponding to the message for which the FCS is calculated is read and combined in the Multiplier/adder, the resulting 123 bit stream (24) is the result of the first division by M123 (24). As indicated in Figure 2, if the multiplier of G used for the first division is M71, the resulting remainder is a 71 bit stream; similarly, if the multiplier of G used in the first division is M53, the resulting remainder is a 53 bit stream.

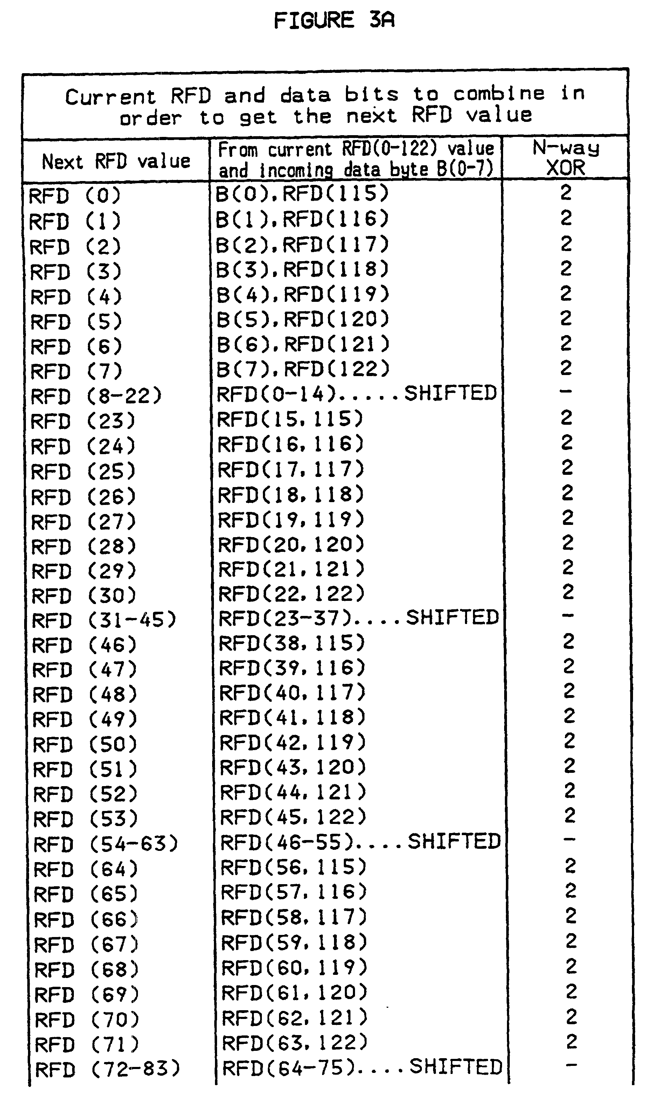

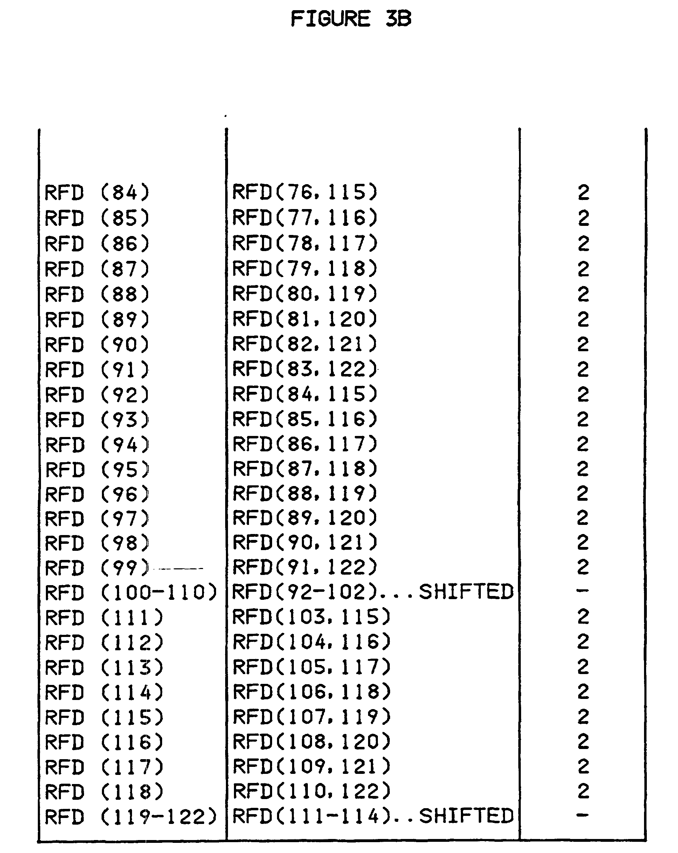

Figure 3 illustrates the combinational part of the state machine for the first division (12) in the case where the polynomial multiplier is M123. The input vector of 123 bits is combined with the incoming new byte N vector. The XOR gate entries are combined in accordance with the calculation in the multiplicative group generated by the polynomial M123 of degree 123. It is noted that the CRC-123 codes calculated with the multiplier/adder of the prior art form a ring and not a Galois Field as the polynomial M123 is not irreducible. However, the same calculation of the prior art for determining the combination of the bits is applied. The bit combinations are listed in the second column of the table, the first column providing the resulting 123 bit vector. In the last column is provided the number of XOR entries necessary to perform the corresponding resulting 123 bit vector calculation. The widest XOR needed is a 2-way XOR.

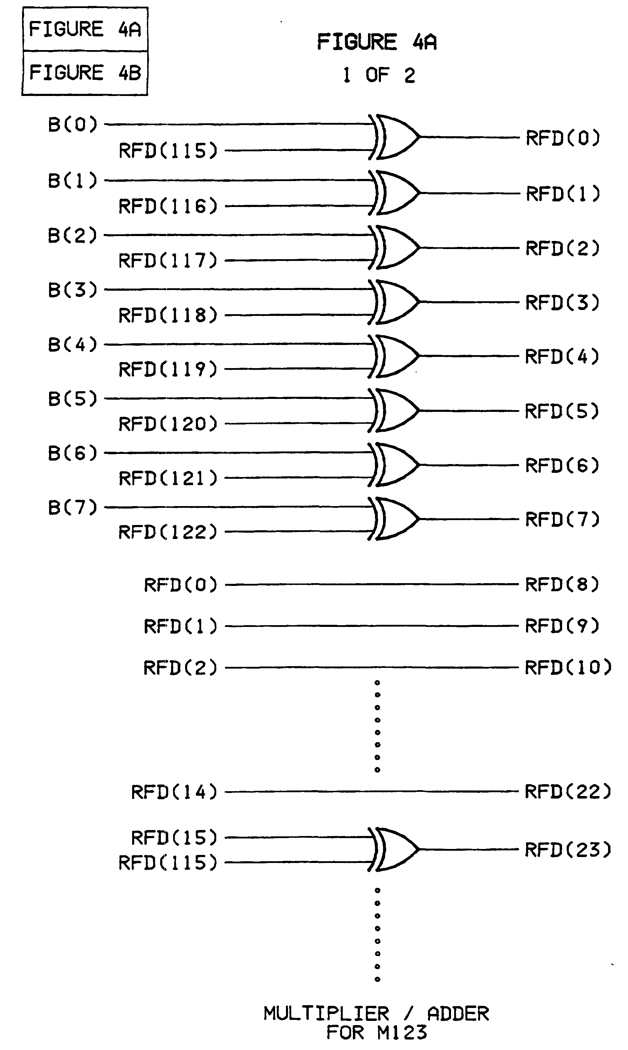

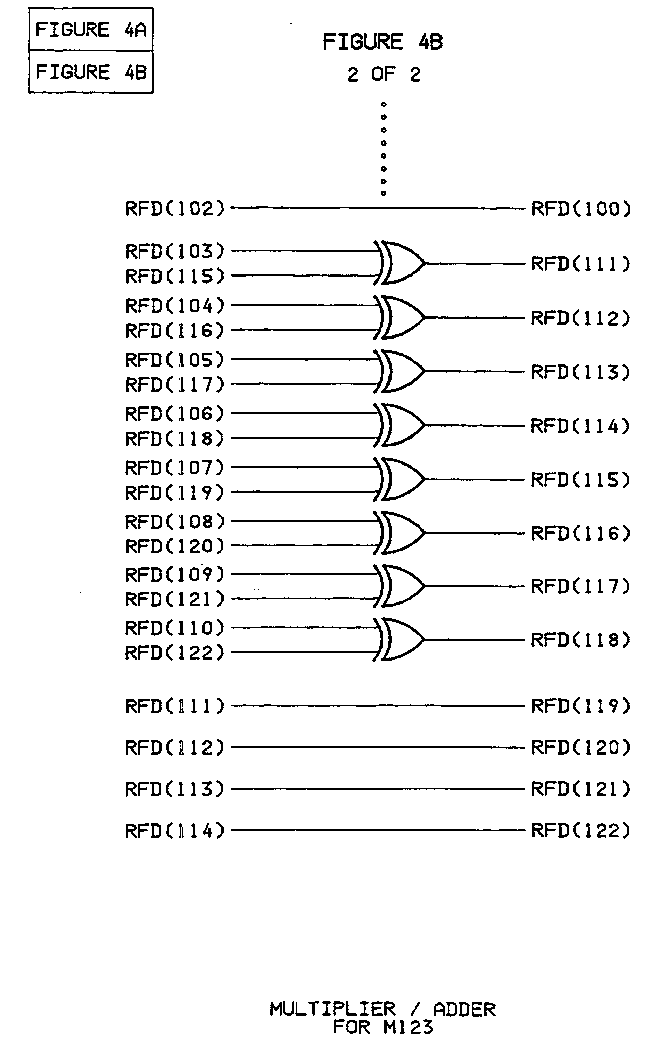

Figure 4A and Figure 4B illustrate one possible implementation of the combinational part of the state machine as listed in column 1 and 2 of Figure 3. The 123 bit stream remainder of the first division (RFD) calculated up to byte N is combined with the bits of byte N+1. Only some bits of the resulting 123 bits remainder are represented in Figure 4A-4B: the first 11 bits (from RFD(0) to RFD(10)), the last bits (RFD(102) to RFD(122)) and the intermediate bits RFD (22) (unchanged from RFD(14)) and RFD(23). The gate used are 2-way XOR.

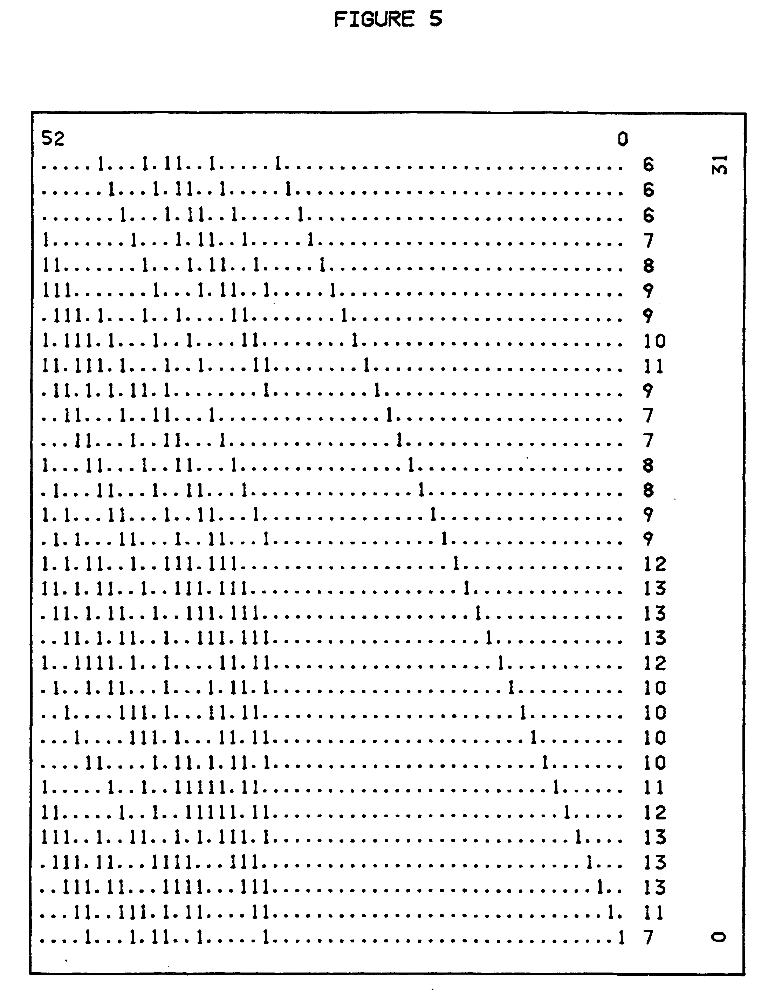

Figure 5A and Figure 5B illustrate the matrix used for performing the final division of the CRC-32 calculation (16). The remainder of the first polynomial division is divided in this step by G(X), the generator polynomial of degree 32, the resulting remainder is a polynomial of degree less than or equal to 31 corresponding to a 32 bit stream. This 32 bit stream is the resulting CRC-32. In the example illustrated in Figure 5A and Figure 5B, the first division was performed by M53, a multiplier of G of degree 53. The 53-bit input vector, result of the first division, is applied on each of the 32 rows to yield the resulting 32 bit vector. The matrix rows correspond to the 53 first elements of the Galois Field generated by the polynomial generator of degree 32 having a root whose the polynomial representation is row 2. The implementation of such a polynomial division of a fixed length vector is a simple combinational array of XORs.

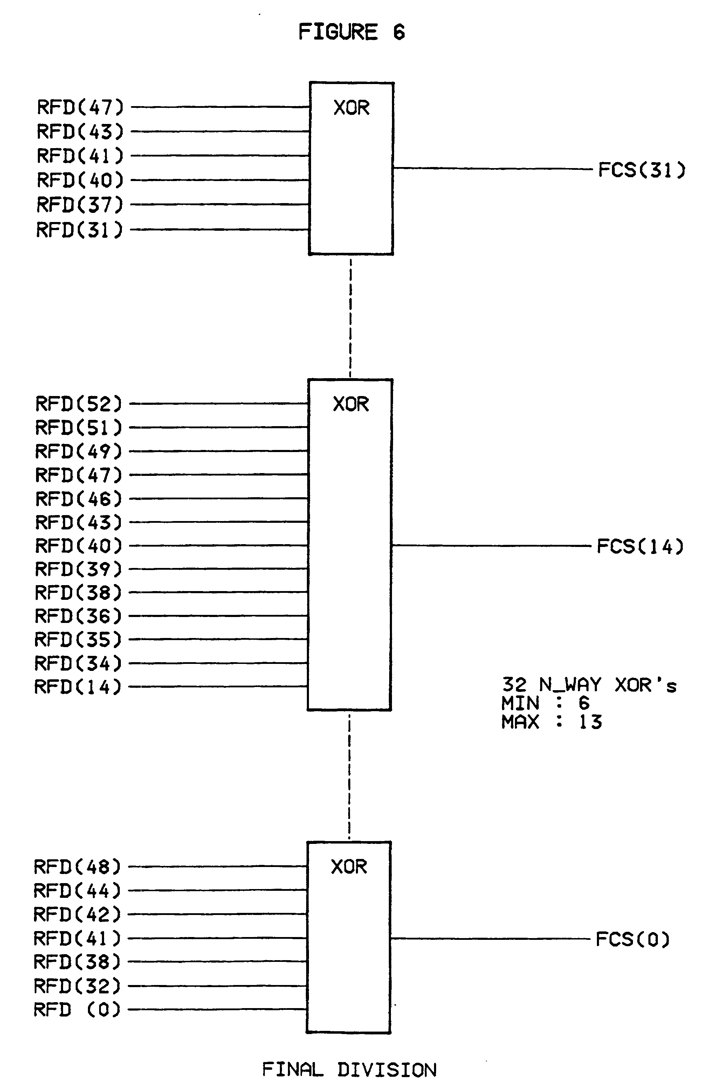

Figure 6 illustrates one possible implementation of the rows of the combinational matrix of Figure 5A and Figure 5B. Each row of the matrix will be implemented with a N-way XOR combining some of the 53 bits to obtain one bit of the resulting CRC-32. The 32 N-way XORs will be from 3 to 13 entries types of XORs. Only the rows 0, 14 and 31 of the matrix of Figure 4A and Figure 4B are illustrated in Figure 6. The 31st bit of the resulting vector is obtained by XORing the bits 47, 43, 41, 40, 37 and 31 of the 53 bit input vector. This operation needs a 6-way XOR. The 14th bit of the resulting vector is obtained by XORing the bits 52, 51, 49, 47, 46, 43, 40, 39, 38, 36, 35, 34, and 14 of the 53 bit input vector. This operation needs a 13-way XOR. The 0 bit of the resulting vector is obtained by XORing the bits 48, 44, 42, 41, 38, 32 and 0 of the 53 bit input vector. This operation needs a 7-way XOR.

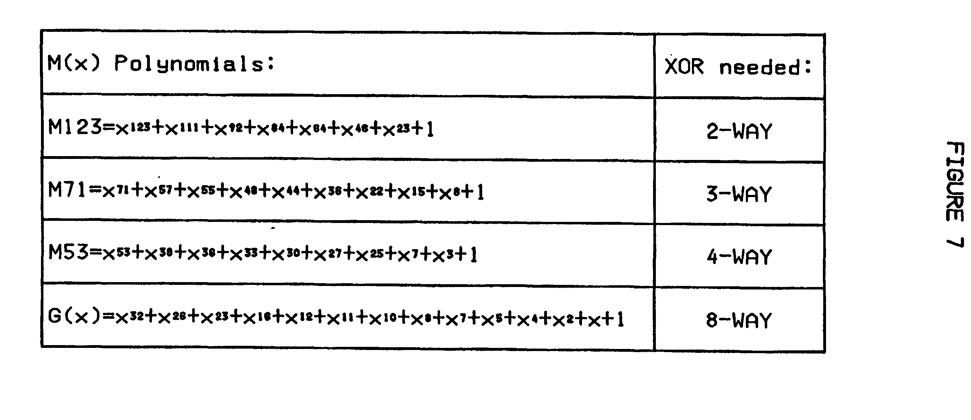

Figure 7 shows the various types of XOR needed for the first per byte division (12) according to the multiplier of G chosen. The simplest is M123 with 2-way XORs. The implementation of the first division with M71 requires 3-way XORs and with M53-4 XORs. This simple type of combinational element is to be compared with the 8-way XORs needed for the division by G. The choice of the multiplier polynomial is lead by the low number of inputs to XORs implying a simple implementation and a short process time. The simplest multiplier identified in Figure 7 being M123 with only 2-way XORs.

**Claims**

1. An apparatus for calculating the 32-bit stream of the CRC-32 Cyclic Redundancy Check code generated by the generator polynomial of degree 32,

$$G(X) = X^{32}+X^{26}+X^{23}+X^{22}+X^{16}+X^{12}+X^{11}+X^{10}+X^8+X^7+X^5+X^4+X^2+X+1,$$

of an input bit stream, said apparatus comprising:

   logic (12) for calculating the R-bit stream of a CRC-R code generated by M(X), which is a multiple of G(X) of degree R, of said input bit stream;

   means for storing (14) the R-bit stream in a R-bit register;

   logic (16) for performing a polynomial division of the stored R-bit stream by G(X), the 32-bit stream remainder of the polynomial division being stored in a 32-bit register (18) and being the 32-bit stream of the CRC-32 code of said input bit stream.

2. The apparatus of claim 1 where the input bit stream is a sequence of 8-bit data bytes and wherein the logic (12) for calculating the R bit-stream performs a per byte calculation.

3. The apparatus of claim 2 where the logic (12) for calculating the R-bit stream comprises:

   a) means for sequentially receiving each byte of said sequence of data bytes in the LSB bits of a R-bit register means;

   b) means for multiplying the content of said R-bit register means by the bit stream corresponding to $\alpha^8$, which is an element of a multiplicative group generated by M(X), $\alpha$ being an irreducible polynomial and primitive element of said multiplicative group,

   c) means for storing the output of said multiplying means in said R-bit register means which is used by the the means for receiving.

4. The apparatus of any one of claims 1 or 3 where the Logic (16) for performing the polynomial division of the stored R-bit stream by G(X) consists of a one pass combinational means between the R bits of the R-bit stream corresponding to the computation in the Galois field generated by G(X).

5. The apparatus of any one of claims 1 to 4 where M(X) is the polynomial of degree R = 123:

$$M123(X) = X^{123}+X^{111}+X^{92}+X^{84}+X^{64}+X^{46}+X^{23}+1$$

6. The apparatus of any one of claims 1 to 4 where M(X) is the polynomial of degree R = 71:

$$M71(X) = X^{71}+X^{57}+X^{55}+X^{48}+X^{44}+X^{36}+X^{22}+X^{15}+X^8+1$$

7. The apparatus of anyone of claims 1 to 4 where M(X) is the polynomial of degree R = 53:

$$M53(X) = X^{53}+X^{38}+X^{36}+X^{33}+X^{30}+X^{27}+X^{25}+X^7+X^3+1$$

8. An apparatus for calculating the frame check sequence FCS of the last AAL5 type cell conveying a bit stream P(X) over an ATM network, said apparatus comprising the following:

- means for inverting the MSB 32 bits of said bit stream P(X),
- apparatus according to anyone of claims 1 to 7 for calculating the 32-bit stream of the CRC-32 code of the output bit stream from said means for inverting the MSB 32 bits,
- means for inverting the calculated 32-bit stream of the CRC-32 code.

9. An apparatus for checking at a receiving point of an ATM network the frame check sequence FCS of a bit stream F'(X) constituted by the payloads of AAL5 type cells conveying a bit stream message sent over the ATM network, the last payload including the FCS of the bit stream message, said apparatus comprising the following:

- means for inverting the MSB 32 bits of said bit stream F'(X),

- apparatus according to anyone of claims 1 to 7 for calculating the 32-bit stream of the CRC-32 code of F'(X),

- means for signaling the positive result of checking only if the polynomial representing the calculated 32-bit stream is:

$$X^{31}+X^{30}+X^{26}+X^{25}+X^{24}+X^{18}+X^{15}+X^{14}+X^{12}+X^{11}+X^{10}+X^{8}+X^{6}+X^{5}+X^{4}+X^{3}+X+1$$

10. A method to calculate the 32-bit stream of the the CRC-32 Cyclic Redundancy Cheek code generated by the generator polynomial of degree 32,

$$G(X) = X^{32}+X^{26}+X^{23}+X^{22}+X^{16}+X^{12}+X^{11}+X^{10}+X^{8}+X^{7}+X^{5}+X^{4}+X^{2}+X+1,$$

of an input bit stream, said method comprising the steps of :

calculating (12) the R-bit stream of a CRC-R code generated by M(X), which is a multiple of G(X) of degree R, of the input bit stream and storing the R-bit stream of the CRC-R code (14);

performing a polynomial division of the stored R-bit stream by G(X), the 32-bit stream remainder of the polynomial division being stored in a 32-bit register (18) and being the 32-bit stream of the CRC-32 code of said input bit stream.

11. The method of claim 10 where the input bit stream is a sequence of 8-bit data bytes and wherein the calculating the R bit-stream step is a per byte calculation.

12. The method of claim 11 wherein the step for calculating the R-bit stream further comprises the steps of:

a) sequentially receiving each byte of said sequence of data bytes in the LSB bits of a R-bit register means;

b) multiplying the content of said R-bit register means by the bit stream corresponding to $\alpha^8$, which is an element of a multiplicative group generated by M(X), $\alpha$ being an irreducible polynomial and primitive element of said multiplicative group,

c) storing the result of said multiplying step in said R-bit register means.

repeating steps a) to c) until the sequence of 8-bit data bytes is all processed.

**Patentansprüche**

1. Vorrichtung zum Berechnen des 32-Bitstroms des CRC-32-Codes der zyklischen Blockprüfung, welcher durch das Generatorpolynom vom Grad 32

9

$$G(X) = X^{32}+X^{26}+X^{23}+X^{22}+X^{16}+X^{12}+X^{11}+X^{10}+X^{8}+X^{7}+X^{5}+X^{4}+X^{2}+X+1$$

eines Eingangsbitstroms generiert wird, wobei die Vorrichtung Folgendes umfasst:

eine Logik (12) zum Berechnen des R-Bitstroms eines durch M(X) generierten CRC-R-Codes, wobei M(X) ein Vielfaches des Polynoms G(X) vom Grad R des eingegebenen Bitstroms ist;

Mittel zum Speichern (14) des R-Bitstroms in einem R-Bit-Register;

eine Logik (16) zum Durchführen einer Polynomdivision des gespeicherten R-Bitstroms durch G(X), wobei der Rest der Polynomdivision des 32-Bitstroms in einem 32-Bit-Register gespeichert wird und gleichzeitig den 32-Bitstrom des CRC-32-Codes des Eingangsbitstroms darstellt.

2. Vorrichtung nach Anspruch 1, wobei der Eingangsbitstrom eine Folge von 8-Bit-Datenbytes ist und wobei die Logik (12) zum Berechnen des R-Bitstroms eine byteweise Berechnung durchführt.

3. Vorrichtung nach Anspruch 2, wobei die Logik (12) zum Berechnen des R-Bitstroms Folgendes umfasst:

a) Mittel zum sequenziellen Aufnehmen jedes Bytes der Folge von Datenbytes in den LSB-Bits (least significant bit, niedrigstwertiges Bit) eines R-Bit-Registermittels;

b) Mittel zum Multiplizieren des Inhalts des R-Bit-Registermittels mit dem $\alpha^8$ entsprechenden Bitstrom, wobei $\alpha^8$ ein Element einer durch M(X) generierten multiplikativen Gruppe und $\alpha$ ein irreduzibles Polynom und Grundelement der multiplikativen Gruppe ist,

c) Mittel zum Speichern der Ausgabewerte des Multiplikationsmittels im R-Bit-Registermittel, welches vom Empfangsmittel verwendet wird.

4. Vorrichtung nach einem der Ansprüche 1 oder 3, wobei die Logik zum Durchführen der Polynomdivision des gespeicherten R-Bitstroms durch G(X) aus einem einstufigen kombinatorischen Mittel zwischen den R Bits des R-Bitstroms besteht, welcher der Berechnung in dem durch G(X) generierten Galois-Feld entspricht.

5. Vorrichtung nach einem der Ansprüche 1 bis 4, wobei M(X) das Polynom vom Grad R = 123 ist:

$$M123(X) = X^{123}+X^{111}+X^{92}+X^{84}+X^{64}+X^{46}+X^{23}+1.$$

6. Vorrichtung nach einem der Ansprüche 1 bis 4, wobei M(X) das Polynom vom Grad R = 71 ist:

$$M71(X) = X^{71}+X^{57}+X^{55}+X^{48}+X^{44}+X^{36}+X^{22}+X^{15}+X^{8}+1.$$

7. Vorrichtung nach einem der Ansprüche 1 bis 4, wobei M(X) das Polynom vom Grad R = 53 ist:

$$M53(X) = X^{53}+X^{38}+X^{36}+X^{33}+X^{30}+X^{27}+X^{25}+X^{7}+X^{3}+1.$$

8. Vorrichtung zum Berechnen der Rahmenprüfbitfolge FCS der letzten Zelle vom AAL5-Typ, welche einen Bitstrom P(X) durch ein ATM-Netz transportiert, wobei die Vorrichtung Folgendes umfasst:

- Mittel zum Umkehren der MSB-32-Bits des Bitstroms P(X),

- Vorrichtung nach einem der Ansprüche 1 bis 7 zum Berechnen des 32-Bitstroms des CRC-32-Codes des vom Mittel zum Umkehren der MSB-32-Bits kommenden Ausgangsbitstroms,

- Mittel zum Umkehren des berechneten 32-Bitstroms des CRC-32-Codes.

9. Vorrichtung zum Prüfen der Rahmenprüfbitfolge FCS eines Bitstroms an einem Empfangspunkt eines ATM-Netzes, der aus den Nutzdaten der Zellen vom AAL5-Typ besteht, welche eine Bitstromnachricht durch das ATM-Netz transportieren, wobei die Nutzdaten der letzten Zelle die FCS der Bitstromnachricht enthalten und die Vorrichtung Folgendes umfasst:

- Mittel zum Umkehren der MSB-32-Bits des Bistroms F'(X),
- Vorrichtung nach einem der Ansprüche 1 bis 7 zum Berechnen des 32-Bitstroms des CRC-32-Codes von F'(X),
- Mittel zum Anzeigen des positiven Prüfergebnisses nur dann, wenn das den berechneten 32-Bitstrom darstellende Polynom gleich:

$$X^{31}+X^{30}+X^{26}+X^{25}+X^{24}+X^{18}+X^{15}+X^{14}+X^{12}+X^{11}+X^{10}+X^8+X^6+X^5+X^4+X^3+X+1$$

ist.

10. Verfahren zum Berechnen des 32-Bitstroms des CRC-32-Codes der zyklischen Blockprüfung, welcher durch das Generatorpolynom vom Grad 32

$$G(X) = X^{32}+X^{26}+X^{23}+X^{22}+X^{16}+X^{12}+X^{11}+X^{10}+X^8+X^7+X^5+X^4+X^2+X+1$$

aus einem Eingangsbitstrom generiert wurde, wobei das Verfahren die folgenden Schritte umfasst:

Berechnen (12) des R-Bitstroms eines durch M(X) generierten CRC-R-Codes, wobei M(X) ein Vielfaches des Polynoms G(X) vom Grad R ist, aus dem Eingangsbitstrom und Speichern des R-Bitstroms des CRC-R-Codes (14);

Durchführen einer Polynomdivision des gespeicherten R- Bitstroms durch G(X), wobei der Rest der Polynomdivision des 32-Bitstroms in einem 32-Bit-Register (18) gespeichert wird und den 32-Bitstrom des CRC-32-Code des Eingangsbitstroms darstellt.

11. Verfahren nach Anspruch 10, wobei der Eingangsbitstrom aus einer Folge von 8-Bit-Datenbytes besteht und der Schritt der Berechnung des R-Bitstroms byteweise erfolgt.

12. Verfahren nach Anspruch 11, wobei der Schritt der Berechnung des R-Bitstroms ferner die folgenden Schritte umfasst:

a) Aufnehmen jedes Bytes der Folge von Datenbytes nacheinander in den LSB-Bits eines R-Bit-Registermittels;

b) Multiplizieren des Inhalts des R-Bit-Registermittels mit dem $\alpha^8$ entsprechenden Bitstrom, wobei $\alpha^8$ ein Element einer durch M(X) generierten multiplikativen Gruppe und $\alpha$ ein irreduzibles Polynom und Grundelement der multiplikativen Gruppe ist,

c) Speichern des Ergebnisses des Multiplikationsschrittes im R-Bit-Registermittel

wobei die Schritte a) bis c) so lange wiederholt werden, bis die gesamte Folge von 8-Bit-Datenbytes verarbeitet ist.

**Revendications**

1. Dispositif destiné à calculer le flux à 32 bits du code de contrôle de redondance cyclique CRC -32 généré par le polynôme générateur de degré 32,

$$G(X) = X^{32} + X^{26} + X^{23} + X^{22} + X^{16} + X^{12} + X^{11} + X^{10} + X^8 + X^7 + X^5 + X^4 + X^2 + X + 1,$$

d'un flux binaire d'entrée, ledit dispositif comprenant :

une logique (12) destinée à calculer le flux à R bits d'un code CRC -R généré par M(x), qui est un multiple de G(x) de degré R, à partir dudit flux binaire d'entrée,

un moyen destiné à mémoriser (14) le flux à R bits dans un registre à R -bits,

une logique (16) destinée à exécuter une division de polynômes du flux à R bits mémorisé par G(X), le reste du flux à 32 bits de la division de polynômes étant mémorisé dans un registre à 32 bits (18) et constituant le flux à 32 bits du code CRC -32 dudit flux binaire d'entrée.

2. Dispositif selon la revendication 1, où le flux binaire d'entrée est une séquence d'octets de données à 8 bits et où la logique (12) pour calculer le flux à R bits exécute un calcul par octet.

3. Dispositif selon la revendication 2, où la logique (12) destinée à calculer le flux à R bits comprend :

a) un moyen destiné à recevoir séquentiellement chaque octet de ladite séquence d'octets de données dans les bits les moins significatifs d'un moyen de registre à R bits,

b) un moyen destiné à multiplier le contenu dudit moyen de registre à R bits par le flux binaire correspondant à $\alpha^8$, qui est un élément d'un groupe multiplicatif engendré par M(x), $\alpha$ étant un polynôme irréductible et un élément premier dudit groupe multiplicatif,

c) un moyen destiné à mémoriser la sortie dudit moyen de multiplication dans ledit moyen de registre à R bits qui est utilisé par le moyen destiné à la réception.

4. Dispositif selon l'une quelconque des revendications 1 ou 3, où la logique (16) destinée à exécuter la division de polynômes du flux de R bits mémorisé par G(X) est constituée d'un moyen de combinaison en une passe entre les R bits du flux à R bits correspondant au calcul du corps de Galois engendré par G(X).

5. Dispositif selon l'une quelconque des revendications 1 à 4, où M(X) est le polynôme de degré R = 123 :

$$M123(X) = X^{123} + X^{111} + X^{92} + X^{84} + X^{64} + X^{46} + X^{23} + 1$$

6. Dispositif selon l'une quelconque des revendications 1 à 4, où M(X) est le polynôme de degré R = 71 :

$$M71(X) = X^{71} + X^{57} + X^{55} + X^{48} + X^{44} + X^{36} + X^{22} + X^{15} + X^8 + 1$$

7. Dispositif selon l'une quelconque des revendications 1 à 4, où M(X) est le polynôme de degré R = 53 :

$$M53(X) = X^{53} + X^{38} + X^{36} + X^{33} + X^{30} + X^{27} + X^7 + X^3 + 1$$

8. Dispositif destiné à calculer la section de contrôle de trame FCS de la dernière cellule de type AAL5 transportant un flux binaire P(X) sur un réseau en mode ATM, ledit dispositif comprenant ce qui suit :

- un moyen destiné à inverser les 32 bits les plus significatifs dudit flux binaire P(X),
- un dispositif selon l'une quelconque des revendications 1 à 7 destiné à calculer le flux à 32 bits du code CRC -32 du flux binaire de sortie provenant dudit moyen en vue d'inverser les 32 bits les plus significatifs,
- un moyen destiné à inverser le flux à 32 bits calculé du code CRC -32.

9. Dispositif destiné à contrôler en un point de réception d'un réseau en mode ATM la séquence de contrôle de trame FCS d'un flux binaire F'(X) constitué des charges utiles des cellules de type AAL5 transportant un message de flux binaire envoyé sur le réseau en mode ATM, la dernière charge utile comprenant la séquence FCS du message de flux binaire, ledit dispositif comprenant ce qui suit :

- un moyen destiné à inverser les 32 bits les plus significatifs dudit flux binaire F'(X),

12

- un dispositif selon l'une quelconque des revendications 1 à 7 destiné à calculer le flux à 32 bits du code CRC-32 de F'(X),

- un moyen destiné à signaler le résultat positif du contrôle uniquement si la représentation polynomiale du flux à 32 bits calculé est :

$$X^{31} + X^{30} + X^{26} + X^{25} + X^{24} + X^{18} + X^{15} + X^{14} + X^{12} + X^{11} + X^{10} + X^8 + X^6 + X^5 + X^4 +$$

$$X^3 + X + 1$$

10. Procédé destiné à calculer le flux à 32 bits du code de contrôle de redondance cyclique CRC -32 généré par le polynôme générateur de degré 32,

$$G(X)=X^{32} + X^{26} + X^{23} + X^{22} + X^{16} + X^{12} + X^{11} + X^{10} + X^8 + X^7 + X^5 + X^4 + X^2 + X + 1,$$

d'un flux binaire d'entrée, ledit procédé comprenant les étapes consistant à :

calculer (12) le flux à R bits d'un code CRC -R généré par M(X), qui est un multiple de G(x) de degré R, du flux binaire d'entrée et mémoriser le flux à R bits du code CRC -R (14),

exécuter une division de polynômes du flux à R bits mémorisé par G(X), le reste du flux à 32 bits de la division des polynômes étant mémorisé dans un registre à 32 bits (18) et constituant le flux à 32 bits du code CRC -32 dudit flux binaire d'entrée.

11. Procédé selon la revendication 10, où le flux binaire d'entrée est une séquence d'octets de données à 8 bits et où l'étape de calcul du flux à R bits est un calcul par octet.

12. Procédé selon la revendication 11, dans lequel l'étape de calcul du flux à R bits comprend en outre les étapes consistant à :

a) recevoir séquentiellement chaque octet de ladite séquence d'octets de données dans les bits les moins significatifs d'un moyen de registre à R bits,

b) multiplier le contenu dudit moyen de registre à R bits par le flux binaire correspondant à $\alpha^8$, qui est un élément d'un groupe multiplicatif engendré par M(X), $\alpha$ étant un polynôme irréductible et un élément premier dudit groupe multiplicatif,

c) mémoriser le résultat de ladite étape de multiplication dans ledit moyen de registre à R bits,

répéter les étapes a) à c) jusqu'à ce que la séquence d'octets de données à 8 bits soit entièrement traitée.

## FIGURE 1

## FIGURE 2

```
                                    ┌──────────────────────────┐
                                    │      NEW BYTE            │~ 20
                                    └─7────────────────────0───┘
                                        │             │
                                        ▼             ▼
                 ┌──────────────────────────────────────────────┐
                 │           MULTIPLIER / ADDER                 │~ 22
                 └─122──────────────────────────────────0───────┘
                 │                              │
             123 │                          123 │
                 │                              ▼
                 │  ┌──────────────────────────────────────────┐
                 │  │   REMAINDER FIRST DIVISION REG.          │~ 24
                 │  └─122────────────────────────────────0─────┘
                 └───────────────────────────│
                                             ▼
                            RESULT FIRST DIVISION ~ 26
```

123 BITS IF M123

71 BITS IF M71

53 BITS IF M53

## FIGURE 3A

| Current RFD and data bits to combine in order to get the next RFD value | | |
|---|---|---|
| Next RFD value | From current RFD(0-122) value and incoming data byte B(0-7) | N-way XOR |
| RFD (0) | B(0), RFD(115) | 2 |
| RFD (1) | B(1), RFD(116) | 2 |
| RFD (2) | B(2), RFD(117) | 2 |
| RFD (3) | B(3), RFD(118) | 2 |
| RFD (4) | B(4), RFD(119) | 2 |
| RFD (5) | B(5), RFD(120) | 2 |
| RFD (6) | B(6), RFD(121) | 2 |
| RFD (7) | B(7), RFD(122) | 2 |
| RFD (8-22) | RFD(0-14).....SHIFTED | — |
| RFD (23) | RFD(15, 115) | 2 |
| RFD (24) | RFD(16, 116) | 2 |
| RFD (25) | RFD(17, 117) | 2 |
| RFD (26) | RFD(18, 118) | 2 |
| RFD (27) | RFD(19, 119) | 2 |
| RFD (28) | RFD(20, 120) | 2 |
| RFD (29) | RFD(21, 121) | 2 |
| RFD (30) | RFD(22, 122) | 2 |
| RFD (31-45) | RFD(23-37)....SHIFTED | — |
| RFD (46) | RFD(38, 115) | 2 |
| RFD (47) | RFD(39, 116) | 2 |
| RFD (48) | RFD(40, 117) | 2 |
| RFD (49) | RFD(41, 118) | 2 |
| RFD (50) | RFD(42, 119) | 2 |
| RFD (51) | RFD(43, 120) | 2 |
| RFD (52) | RFD(44, 121) | 2 |
| RFD (53) | RFD(45, 122) | 2 |
| RFD (54-63) | RFD(46-55)....SHIFTED | — |
| RFD (64) | RFD(56, 115) | 2 |
| RFD (65) | RFD(57, 116) | 2 |
| RFD (66) | RFD(58, 117) | 2 |
| RFD (67) | RFD(59, 118) | 2 |
| RFD (68) | RFD(60, 119) | 2 |
| RFD (69) | RFD(61, 120) | 2 |
| RFD (70) | RFD(62, 121) | 2 |
| RFD (71) | RFD(63, 122) | 2 |
| RFD (72-83) | RFD(64-75)....SHIFTED | — |

## FIGURE 3B

| | | |
|---|---|---|
| RFD (84) | RFD(76, 115) | 2 |
| RFD (85) | RFD(77, 116) | 2 |
| RFD (86) | RFD(78, 117) | 2 |
| RFD (87) | RFD(79, 118) | 2 |
| RFD (88) | RFD(80, 119) | 2 |
| RFD (89) | RFD(81, 120) | 2 |
| RFD (90) | RFD(82, 121) | 2 |
| RFD (91) | RFD(83, 122) | 2 |
| RFD (92) | RFD(84, 115) | 2 |
| RFD (93) | RFD(85, 116) | 2 |
| RFD (94) | RFD(86, 117) | 2 |
| RFD (95) | RFD(87, 118) | 2 |
| RFD (96) | RFD(88, 119) | 2 |
| RFD (97) | RFD(89, 120) | 2 |
| RFD (98) | RFD(90, 121) | 2 |
| RFD (99) | RFD(91, 122) | 2 |
| RFD (100-110) | RFD(92-102)...SHIFTED | — |
| RFD (111) | RFD(103, 115) | 2 |
| RFD (112) | RFD(104, 116) | 2 |
| RFD (113) | RFD(105, 117) | 2 |
| RFD (114) | RFD(106, 118) | 2 |
| RFD (115) | RFD(107, 119) | 2 |
| RFD (116) | RFD(108, 120) | 2 |
| RFD (117) | RFD(109, 121) | 2 |
| RFD (118) | RFD(110, 122) | 2 |
| RFD (119-122) | RFD(111-114)..SHIFTED | — |

FIGURE 4A

FIGURE 4B

FIGURE 4A

1 OF 2

MULTIPLIER / ADDER
FOR M123

FIGURE 4A

FIGURE 4B

RFD(102) ——————————————— RFD(100)

RFD(103) ——
RFD(115) ——⊃⟩ RFD(111)

RFD(104) ——
RFD(116) ——⊃⟩ RFD(112)

RFD(105) ——
RFD(117) ——⊃⟩ RFD(113)

RFD(106) ——
RFD(118) ——⊃⟩ RFD(114)

RFD(107) ——
RFD(119) ——⊃⟩ RFD(115)

RFD(108) ——
RFD(120) ——⊃⟩ RFD(116)

RFD(109) ——
RFD(121) ——⊃⟩ RFD(117)

RFD(110) ——
RFD(122) ——⊃⟩ RFD(118)

RFD(111) ——————————————— RFD(119)

RFD(112) ——————————————— RFD(120)

RFD(113) ——————————————— RFD(121)

RFD(114) ——————————————— RFD(122)

MULTIPLIER / ADDER
FOR M123

## FIGURE 5

```
52                                                    0
     .....1...1.11..1.....1........................ 6      31
     ......1...1.11..1.....1....................... 6
     .......1...1.11..1.....1...................... 6
     1.......1...1.11..1.....1..................... 7
     11.......1...1.11..1.....1.................... 8
     111.......1...1.11..1.....1................... 9
     .111.1...1..1....11........1.................. 9
     1.111.1...1..1....11.......1.................. 10
     11.111.1...1..1....11.......1................. 11
     .11.1.1.11.1........1........1................ 9
     ..11...1..11...1..............1............... 7
     ...11...1..11...1.............1............... 7
     1...11...1..11...1............1............... 8
     .1...11...1..11...1...........1............... 8
     1.1...11...1..11...1..........1............... 9
     .1.1...11...1..11...1.........1............... 9
     1.1.11..1..111.111................1........... 12
     11.1.11..1..111.111..............1........... 13
     .11.1.11..1..111.111.............1........... 13
     ..11.1.11..1..111.111............1........... 13
     1..1111.1..1...11.11.............1........... 12
     .1..1.11...1....1.11.1...........1........... 10
     ..1....111.1...11.11................1........ 10
     ...1....111.1...11.11...............1........ 10
     ....11....1.11.1.11.1...............1........ 10
     1.....1..1..11111.11.................1...... 11
     11.....1..1..11111.11...............1..... 12
     111..1..11...1.1.111.1...............1.... 13
     .111.11...1111...111.................1... 13
     ..111.11...1111...111................1.. 13
     ...11..111.1.11....11................1. 11
     ....1...1.11..1.....1................1 7      0
```

## FIGURE 6

RFD(47) ——————
RFD(43) ——————
RFD(41) ——————  XOR ————————— FCS(31)
RFD(40) ——————
RFD(37) ——————
RFD(31) ——————

RFD(52) ——————
RFD(51) ——————
RFD(49) ——————
RFD(47) ——————
RFD(46) ——————
RFD(43) ——————  XOR ————————— FCS(14)
RFD(40) ——————
RFD(39) ——————
RFD(38) ——————
RFD(36) ——————
RFD(35) ——————
RFD(34) ——————
RFD(14) ——————

32 N_WAY XOR's
MIN : 6
MAX : 13

RFD(48) ——————
RFD(44) ——————
RFD(42) ——————
RFD(41) ——————  XOR ————————— FCS(0)
RFD(38) ——————
RFD(32) ——————
RFD (0) ——————

FINAL DIVISION

EP 0 840 462 B1

| M(x) Polynomials: | XOR needed: |
|---|---|
| M123=$x^{123}+x^{111}+x^{92}+x^{84}+x^{64}+x^{46}+x^{23}+1$ | 2-WAY |
| M71=$x^{71}+x^{57}+x^{55}+x^{48}+x^{44}+x^{38}+x^{22}+x^{15}+x^{8}+1$ | 3-WAY |
| M53=$x^{53}+x^{38}+x^{36}+x^{33}+x^{30}+x^{27}+x^{25}+x^{7}+x^{3}+1$ | 4-WAY |
| G(x)=$x^{32}+x^{26}+x^{23}+x^{16}+x^{12}+x^{11}+x^{10}+x^{8}+x^{7}+x^{5}+x^{4}+x^{2}+x+1$ | 8-WAY |

FIGURE 7